(19) Europäisches Patentamt
European Patent Office
Office européen des brevets

(11) Veröffentlichungsnummer : **0 388 484 B1**

(12) # EUROPÄISCHE PATENTSCHRIFT

(45) Veröffentlichungstag der Patentschrift :
**21.09.94 Patentblatt 94/38**

(51) Int. Cl.[5] : **G03F 7/023,** G03F 7/075

(21) Anmeldenummer : **89104950.4**

(22) Anmeldetag : **20.03.89**

(54) **Hochauflösender Photoresist.**

(43) Veröffentlichungstag der Anmeldung :
**26.09.90 Patentblatt 90/39**

(45) Bekanntmachung des Hinweises auf die Patenterteilung :
**21.09.94 Patentblatt 94/38**

(84) Benannte Vertragsstaaten :
**BE CH DE ES FR GB IT LI NL SE**

(56) Entgegenhaltungen :
**EP-A- 0 070 201**
**EP-A- 0 229 629**
**WO-A-89/07786**
**BE-A- 569 763**
**DE-A- 1 447 010**
**DE-A- 2 217 744**
**DE-B- 2 718 130**
**FR-A- 2 477 294**
**US-A- 2 990 281**
**US-A- 4 720 445**
**PATENT ABSTRACTS OF JAPAN, Band 10, Nr. 154 (P-463)[2210], 4. Juni 1986; & JP-A-61 7835**

(56) Entgegenhaltungen :
**PLASMA CHEMISTRY AND PLASMA PROCESSING, Band 6, Nr. 4, Dezember 1986, Seiten 401-415, Plenum Publisching Corp., Bristol, GB; S.J.MOSS et al.: "Plasmaoxidation of polymers"**
**IBM TECHNICAL DISCLOSURE BULLETIN, Band 23, Nr. 7B, Dezember 1980, Seite 3203,New York, US; W.M. MOREAU: "Shelf life extender for polymeric material"**

(73) Patentinhaber : **SIEMENS AKTIENGESELLSCHAFT**
**Wittelsbacherplatz 2**
**D-80333 München (DE)**

(72) Erfinder : **Sebald, Michael, Dr. rer. nat., Dipl.-Chem.**
**Kirchensteig 3**
**D-8521 Hessdorf (DE)**
Erfinder : **Sezi, Recai, Dr. Ing., Dipl.-Chem.**
**Weiherstrasse 14**
**D-8551 Röttenbach (DE)**
Erfinder : **Leuschner, Rainer, Dr. rer. Nat., Dipl.-Chem.**
**Buchenweg 2**
**D-8521 Grossenseebach (DE)**
Erfinder : **Birkle, Siegfried, Dr. rer. nat., Dipl.-Chem.**
**Veit-Stoss-Strasse 46**
**D-8552 Höchstadt (DE)**
Erfinder : **Ahne, Hellmut, Dr. Ing., Dipl.-Chem.**
**Heideweg 7**
**D-8551 Röttenbach (DE)**

EP 0 388 484 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen wäßrig-alkalisch entwickelbaren Photoresist zur Strukturerzeugung im sub-μm-Bereich, bestehend aus einem entwickelbaren Basispolymer, einer photoaktiven Komponente und gegebenenfalls weiteren üblichen Zusätzen.

Zur photolithographischen Strukturerzeugung bzw. Strukturübertragung von einer Vorlage (Maske) auf ein Substrat, zum Beispiel einen Wafer, werden heutzutage üblicherweise positiv arbeitende, wäßrig-alkalisch entwickelbare Photoresists verwendet. Diese Resists bestehen im wesentlichen aus einem alkalilöslichen Basispolymer und einer photoaktiven Komponente (PAC). Ihre Wirkungsweise beruht auf dem Lösungsinhibitorprinzip, das heißt, die Anwesenheit der hydrophoben PAC reduziert weitgehend die Löslichkeit des Basispolymers im wäßrig-alkalischen Entwickler. Erst bei Bestrahlung des Resists mit Licht geeigneter Wellenlänge wird die PAC in einem photochemischen Prozeß in eine hydrophile Verbindung umgewandelt. In den belichteten Bereichen stehen nun polare und somit hydrophile Gruppen zur Verfügung, die einen Angriff des Entwicklers ermöglichen. Bei diesem Vorgang wird das Basispolymer vom Entwickler chemisch aufgelöst, und zwar ausschließlich in den einem Angriff zugänglichen belichteten Bereichen.

Gängige Photoresists sind auf eine Photolithographie mit sichtbarem Licht (zum Beispiel 436 nm) oder im nahen UV (zum Beispiel 365 nm) abgestimmt. Aufgrund physikalischer Gesetze können mit diesen Photoresistsystemen jedoch nur Strukturen bis ca. 0,5 μm optisch aufgelöst und somit erzeugt werden. Gemäß der Formel:

$$CD = k \frac{\lambda}{NA}$$

ist die kleinste abgebildete Struktur CD proportional der zur Belichtung verwendeten Wellenlänge λ. NA ist die numerische Apertur und stellt eine Kenngröße der für die Abbildung verwendeten Optik dar, während k ein prozeßspezifischer Faktor ist.

Um in der Mikroelektronik die Integrationsdichte von integrierten Schaltungen oder Speicherbausteinen weiter zu erhöhen, müssen die Strukturdimensionen weiter reduziert werden. Auf photolithographischem Weg kann dies zum Beispiel durch eine Verringerung der Wellenlänge des zur Abbildung verwendeten Lichts erreicht werden. Für tiefes UV-Licht (DUV) mit Wellenlängen unterhalb von 300 nm sind jedoch besondere Resistsysteme erforderlich. Neben einer im tiefen UV "zerfallenden" PAC ist insbesondere ein für diesen Wellenlängenbereich transparentes Basispolymer erforderlich. Während die photoaktive Komponente dabei anfänglich eine hohe Absorption zeigen soll, um eine hohe Empfindlichkeit zu gewährleisten, muß sie im Verlauf der abbildenden Belichtung ausbleichen, das heißt, nach der photochemischen Reaktion für die belichtende Strahlung wieder transparent werden. Je geringer die Restabsorption des Resists ist, desto tiefer kann das Licht in die Resistschicht eindringen und desto höher ist das Auflösungsvermögen, der Kontrast und die Flankensteilheit der so erzeugten Strukturen. Auf den nahen UV-Bereich (NUV) abgestimmte bekannte Resistsysteme zeigen jedoch eine hohe Restabsorption der Basispolymere im DUV und verlieren beim Übergang auf eine Belichtungswellenlänge von zum Beispiel 248 nm (KrF-Excimer-Laser als Lichtquelle) ihre hervorragenden Eigenschaften. Dies äußert sich in schlechten Werten für Kontrast, Empfindlichkeit, Auflösungsvermögen und Flankensteilheit der Strukturen. Daher müssen für eine DUV-Lithographie neue Resists entwickelt werden.

Ein weiteres Problem beim Übergang auf kurzwelligeres Licht schafft die mit der Wellenlänge ebenfalls reduzierte Fokustiefe DOF, die sich gemäß der Formel

$$DOF = \pm f\left(\frac{\lambda}{(NA)^2}\right)$$

ebenfalls proportional zu λ verhält. Das bedeutet, daß die Kontrastschärfe abgebildeter Strukturen bei dünnen Resistschichten besser gewährleistet ist. Insbesondere für Substrate mit einer Stufen aufweisenden Topographie sind jedoch dicke Resistschichten erforderlich, um zum Beispiel eine Planarisierung zu erreichen.

Dieses Problem wird von der sogenannten Zweilagentechnik gelöst, bei der auf dem Substrat zunächst eine optisch dichte planarisierende erste Resistschicht aufgebracht wird, die anschließend mit einer zweiten, dünnen photolithographisch strukturierbaren Resistschicht abgedeckt wird. Bei der nachfolgenden Strukturierung wird zunächst nur diese zweite Resistschicht belichtet und entwickelt. Die entstehende Struktur dient nun als Maske zur Strukturierung der ersten Resistschicht durch ein anisotropes Ätzverfahren, zum Beispiel mit sauerstoffhaltigem Plasma.

Mit dieser Technik werden sowohl die Unebenheiten des Substrats ausgeglichen, als auch störende Reflexionen von der Substratoberfläche während der Belichtung verhindert. Erforderlich ist dafür jedoch eine ausreichende Ätzresistenz der Topresist genannten zweiten strukturierbaren Resistschicht gegenüber zum Beispiel Sauerstoffplasma. Dies wird durch den Einbau von bestimmten Elementen, zum Beispiel Silizium, in das Basispolymer erreicht. Im Sauerstoffplasma bilden sich aus diesen Elementen nichtflüchtige Oxide, die die Topresiststrukturen vor weiterem Ätzangriff schützen.

Als Basispolymere für DUV-geeignete Photoresists werden in einem Artikel von T. R. Pampalone in der Zeitschrift Solid State Technology, Juni 1984, Seite 115 Kresol-Novolake vorgeschlagen. Diese sind für ihre Ätzresistenz im Halogenplasma bekannt und dienen bereits in käuflichen Photoresists als Basispolymere für längerwellige Lithographieverfahren. Doch selbst mit zunehmendem Anteil von para-Kresol im als Isomerengemisch vorliegenden Novolak kann die Transmission für tiefes UV-Licht verbessert werden, jedoch nicht unter einen Absorptionskoeffizient $\alpha_{248}$ von 0,3 $\mu m^{-1}$ verringert werden. Dieser Wert liegt in einem Bereich, der die Anwendungsmöglichkeit dieses Polymers in DUV-Resists begrenzt.

Das im gleichen Artikel für NUV- und DUV-Photoresists vorgeschlagene Poly(4-hydroxystyrol) besitzt zwar eine mit Novolaken vergleichbare Ätzresistenz, zeigt aber in Resistmischungen aufgrund seiner hohen Alkalilöslichkeit nicht akzeptable hohe Dunkelabtragungsraten bei der Entwicklung und ist daher als Photoresist für sub-µm-Strukturen ungeeignet.

Ein weiteres Photoresistsystem für den DUV-Bereich wird von C. E. Osuch et al in SPIE Vol. 631, Advances in Resisttechnology and Processing III (1986), Seite 68 bis 75 beschrieben. Ein Styrol-Maleinsäureimid-Copolymer mit tert.-Butoxy-carbonyl-Einheiten zur Blockierung der Imidgruppen wird dort als Basispolymer zusammen mit einer säurebildenden photoaktiven Komponente in einem alkalilöslichen und im DUV strukturierbaren Photoresist verwendet.

Dieses System hat jedoch den Nachteil, daß es während der Belichtung nicht ausbleicht und deshalb auf relativ dünne Filmdicken beschränkt ist. Außerdem erfordert das Entwicklungsverfahren einen zusätzlichen Temperaturschritt, der zu einem Schichtdickenverlust von ca. 10 Prozent führt und entsprechend dickere Resistschichten erforderlich macht. Und schließlich werden mit diesem System nur Strukturen bis ca. 0,75 µm aufgelöst (bei 1,25 µm Schichtdicke).

Für die Zweilagenresisttechnik werden weitere DUV-Photoresists vorgeschlagen. Ein Copolymer aus Trimethylsilylmethyl-methacrylat und Methacrylsäure im Molverhältnis 1:1 wird zum Beispiel als alkalilösliches Basispolymer mit 2-Nitrobenzyl-cholat als photoaktive Komponente für siliziumhaltige DUV-Topresists verwendet. Doch hat dieses System einen relativ niedrigen Siliziumgehalt von ca. 8 Prozent, eine niedrige Photoempfindlichkeit von 200 $mJ/cm^2$ und nur eine maximale Auflösung von ca. 0,75 µm, weshalb auch hier die Anwendungsmöglichkeiten beschränkt sind.

Die Trimethylsilylgruppen im alkaliunlöslichen Basispolymer Poly(4-trimethylsiloxy-styrol) können durch eine starke Säure unter Bildung von Phenolgruppierungen abgespalten werden. Mit einem Oniumsalz als photoaktive Komponente ist dieses Polymer daher, wenn auch beschränkt, als DUV-Resist geeignet. Es bleicht allerdings während der Belichtung nicht aus und weist daher lediglich einen Kontrast von ca. 1,2 auf. Auch der niedrige Erweichungspunkt des Basispolymers von ca. 76°C schließt seine Verwendung als Topresist für einen Sauerstoffplasmaschritt, bei dem Temperaturen von ca. 100°C auftreten, aus.

Aufgabe der vorliegenden Erfindung ist es daher, DUV-transparente Basispolymere für die Verwendung in wäßrig-alkalisch entwickelbaren Photoresists anzugeben, welche sowohl für die Einlagen- als auch für die Zweilagentechnik geeignet sind.

Diese Aufgabe wird durch einen Photoresist mit den Merkmalen von Anspruch 1 gelöst. Weitere Ausgestaltungen der Erfindung sind den Unteransprüchen zu entnehmen.

Die im erfindungsgemäßen Photoresist enthaltenen Basispolymere weisen eine hohe DUV-Transparenz ($\alpha_{248}$ kleiner als 0,1 $\mu m^{-1}$) auf und sind daher selbst für solche Anwendungen geeignet, die eine hohe Schichtdicke des Photoresists auf einem Wafer oder einem beliebigen anderen Substrat erfordern. Eine hohe Glasübergangstemperatur von größer 160°C zeigt die hohe thermische Stabilität solcher Basispolymere bzw. der die Basispolymere enthaltenden Photoresistzusammensetzungen und erschließt diesem vielfältige Anwendungsmöglichkeiten. So sind die erfindungsgemäßen DUV-Photoresists insbesonders für Plasmaätzverfahren mit hohen auftretenden Temperaturen geeignet, da eine Gefahr der Erweichens oder gar Verfließens der Photoresistschichten während des Ätzprozesses oder anderer Hochtemperaturschritte nicht besteht.

Mit gängigen photoaktiven Komponenten, zum Beispiel Chinondiaziden erzielt der Positivphotoresist einen hohen Kontrast. Dieser ist die Folge des großen Polaritätsunterschieds zwischen der hydrophoben Anhydridfunktion und der beim Entwicklungsprozeß entstehenden polaren Carbonsäurefunktion. Trotz guter Entwicklungsfähigkeit des Photoresists zeigt dieser nur einen geringen Dunkelabtrag von bis zu 5 nm. Bei einer Photoresistschicht von 1,0 µm Schichtdicke entspricht dies nur 0,5 Prozent. Mit Dunkelabtrag wird im übrigen die Abnahme der Schichtdicke einer unbelichteten Photoresistschicht im Entwicklungsverfahren bezeichnet. Ein geringerer Dunkelabtrag macht auch eine geringere Schichtdicke des Photoresists erforderlich, um zu einer gewünschten Strukturhöhe bei den entwickelten Photoresiststrukturen zu gelangen. Auch dies trägt zu einer Verbesserung des Kontrasts bei, da eine dünnere Resistschicht in einem lithographischen Verfahren bessere Auflösung zeigt als eine dickere. Die hohe Transparenz des Basispolymeren wiederum sorgt für eine gute Auflösung selbst bei höheren Schichtdicken und erzeugt Strukturen mit steilen Flanken.

Die Auswahl der als Basispolymere geeigneten Verbindungen ist dabei nicht weiter begrenzt, da allein mit der erfindungsgemäß enthaltenen Anhydridfunktion die aufgeführten Vorteile erzielt werden. So kann das Basispolymer zum Beispiel cyclische Anhydridfunktionen aufweisen, wobei diese sowohl in der Hauptkette als auch in Seitenketten des Basispolymers enthalten sein können. Auch nicht-cyclische, also lineare Anhydride sind möglich. Ein besonderer Vorteil wird erzielt, wenn Bestandteile der Hauptkette des Basispolymeren mit Anhydridbindungen verknüpft sind. Da bei der Entwicklung des Anhydrid enthaltenden Photoresists die Anhydridfunktion hydrolisiert wird, wird in diesem Fall auch die Kette des Basispolymeren "gesprengt" und somit dessen Löslichkeit im Entwicklungsverfahren verstärkt.

Ein erfindungsgemäßer Photoresist kann ein Basispolymer enthalten, das zu 1 bis 100 Mol-Prozent von die Anhydridfunktion tragenden Monomeren abgeleitet ist. Vorteilhaft und gut zugänglich ist ein Basispolymer, das zu 10 bis 55 Mol-Prozent aus Maleinsäureanhydridmonomeren abgeleitet ist. Wird als Basispolymer ein Copolymer aus Maleinsäureanhydrid (oder beliebigen anderen Anhydridfunktionen tragenden Monomeren) und weiteren Monomeren für den Photoresist verwendet, so können die weiteren Monomere des Copolymers so ausgewählt sein, daß die Ätzresistenz des Photoresists gegen Plasmaätzverfahren erhöht wird. Insbesondere können solche weiteren Monomere erfindungsgemäß siliziumorganische Verbindungen sein, welche die Ätzresistenz des Photoresists gegen sauerstoffhaltiges Ätzplasma erhöhen. Für Anwendungen des Photoresists als Maske in einem halogenhaltigen Plasmaätzverfahren sind aromatische Gruppierungen von Vorteil, so daß als weitere Monomere auch aromatische Verbindungen ausgewählt werden können. Erfindungsgemäße weitere Monomere gehorchen den folgend dargestellten Strukturformeln A, B, C und D),

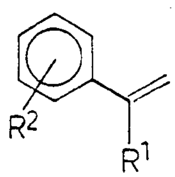
A

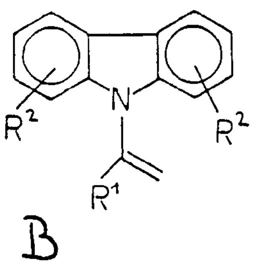
B

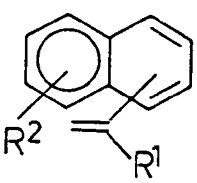
C

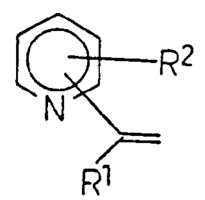
D

wobei $R^1$ und $R^2$ unabhängig voneinander für H, Alkyl, Aryl oder Halogen stehen.

Eine Verstärkung der Ätzresistenz des Photoresists gegenüber sauerstoffhaltigem Plasma wird sowohl durch silizium- als auch durch zinnhaltige Verbindungen erzielt. Beispielsweise können als weitere Monomere daher auch Verbindungen eingesetzt werden, die zumindest einer der beiden Strukturformeln E und F entsprechen,

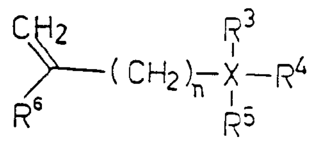
E

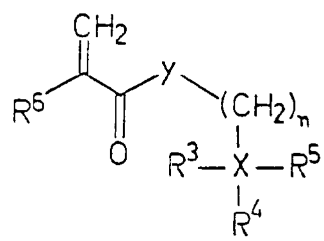
F

wobei $0 \leqq n \leqq 3$, $R^3$ bis $R^5$ unabhängig voneinander je einen Alkyl-, Aryl-, Alkoxy-, Aryloxy- oder Arylalkylrest darstellen, $R^6$ H oder Alkyl bedeutet, Y für O oder NH und X für Si oder Sn steht. Ein erfindungsgemäßer Photoresist kann daher ein Basispolymer mit der Struktur G aufweisen,

G 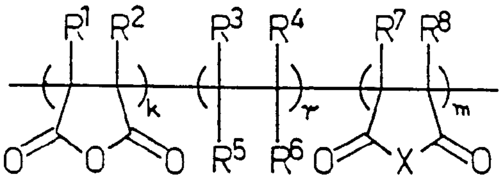

wobei das Strukturfragment mit dem Index k in einem Anteil von 10 bis 55 Prozent der Strukturfragmente an der Gesamtstruktur beteiligt ist, k, r und m ganze Zahlen darstellen und r oder m den Wert O annehmen können, $R^1$ bis $R^8$ Wasserstoff, Alkyl, Aryl, Halogen, halogensubstituiertes Alkyl bzw. Aryl oder einen olefinisch ungesättigten Rest bedeuten, $R^3$ außerdem Methoxyphenyl,

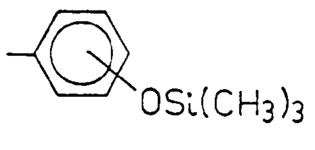 , 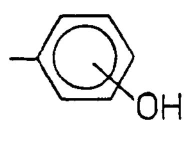 , 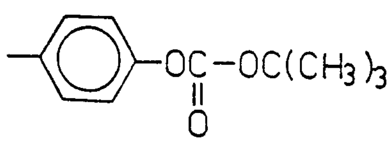 ,

$-COOH$, $-COOR$, $-CH_2Si(CH_3)_3$, $-Si(CH_3)_3$, $-Si(OCH_3)_3$ und X = O, NR oder S ist mit R = H, Alkyl, Aryl, Vinyl, Allyl oder Acryl. Als regelmäßig wiederkehrende Einheiten kann das Basispolymer außerdem den Strukturformeln H, I und K gehorchende Fragmente in der Kette aufweisen:

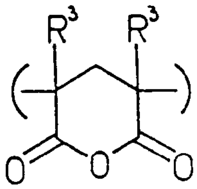 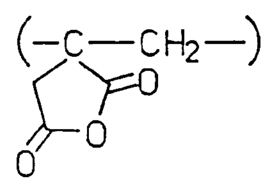 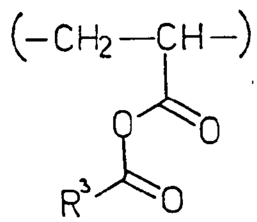

H I K

wobei $R^3$ für die bereits angegebenen Gruppen stehen kann. Desweiteren kann das Basispolymer von Anhydridmonomeren abgeleitet sein, die zumindest einer der Strukturen L, M, N oder O gehorchen,

L 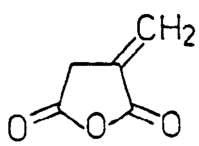 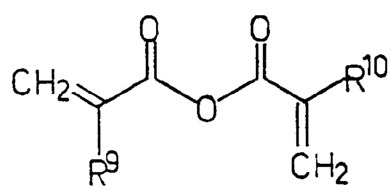 M

N 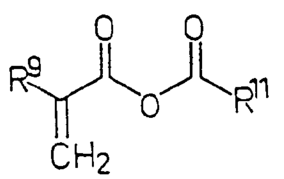 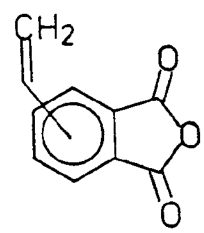 O

wobei $R^9$ und $R^{10}$ für H oder Alkyl stehen und $R^{11}$ einen Alkyl- oder Arylrest darstellt.

An die photoaktive Komponente werden keine besonderen Voraussetzungen gestellt. Für positiv arbeitende Photoresists können beliebige PAC's verwendet werden, sofern sie eine der Belichtungswellenlänge angepaßte Schwellenenergie aufweisen und infolge eben dieser Belichtung durch photochemische Reaktion in Verbindungen mit veränderter Polarität und somit verändertem Lösungs- bzw. Lösungsinhibitorverhalten übergehen. Gebräuchlich und für die erfindungsgemäßen Photoresists gut geeignet sind Chinondiazide als PAC's. Beispielsweise kann die PAC einer der Strukturformeln P, Q, R oder S gehorchen oder von diesen abgeleitet sein,

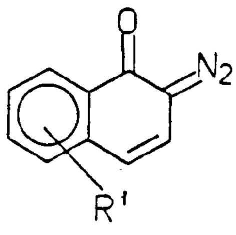
P

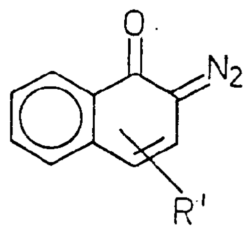
Q

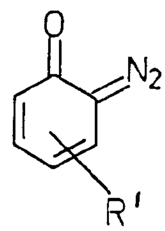
R

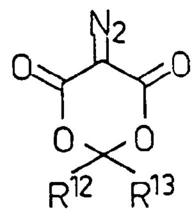
S

wobei $R^{12}$ und $R^{13}$ unabhängig voneinander für einen beliebigen organischen Rest oder eine Arylgruppe stehen, R' kann $-SO_3R$ oder $-CO_2R$ bedeuten, wobei R für Alkyl, Aryl, Halogenalkyl, Halogenaryl oder Halogen steht. Aus derartigen photoaktiven Komponenten entsteht durch Stickstoffabspaltung und Umlagerung eine Carbonsäure, so daß die belichteten Bereiche einer diese PAC enthaltenden Photoresistschicht einem hydrophilen Angriff der alkalischen Entwicklerlösung zugängig werden. Die PAC unterstützt hier nicht die Auflösung des Basispolymeren, sondern erleichtert lediglich den Angriff des Entwicklers durch positive polare Wechselwirkungen.

In einer weiteren Ausgestaltung der Erfindung sind als PAC Radikalbildner oder Bisazide vorgesehen, mit denen der Photoresist als Negativresist wirkt. Ein Radikalbildner unterstützt bei Belichtung eine Vernetzung des Basispolymeren und setzt somit dessen Löslichkeit herab. Mit einer entsprechend stärkeren Entwicklerlösung werden dann die unbelichteten Teile der Photoresistschicht herausgelöst, während die belichteten und somit vernetzten Bereiche der Photoresistschicht der Entwicklerlösung widerstehen.

Der Anteil der im Photoresist enthaltenen PAC ist relativ hoch, da die lösungsvermittelnden bzw. die lösungsinhibierenden Eigenschaften der PAC auf den Photoresist übertragen werden sollen. Üblicherweise ist die PAC in einem Anteil von 10 bis 35 Gewichtsprozent im trockenen und lösungsmittelfreien Resist enthalten. Aufgrund der gewichtsbezogenen Angabe kann dieser Wert mit dem Mol-Gewicht der PAC variieren, liegt aber meist zwischen 15 und 25 Gewichtsprozent. Die effektiv eingesetzte PAC ist dabei von den angegebenen Strukturen abgeleitet und mit ihren Resten auf das Basispolymer abgestimmt. Ausgehend zum Beispiel von den mit reaktiven Carbonsäure- bzw. Sulfonsäurederivaten substituierten Chinondiaziden kommen als effektiv eingesetzte PAC die Umsetzungsprodukte mit aromatischen oder aliphatischen H-aciden Verbindungen wie Alkoholen, Phenolen und Aminen in Frage. Eine besonders geeignete photoaktive Komponente ist der 4- bzw. 5-Sulfonsäureester von Naphthochinondiazid mit mehrwertigen Phenolen wie beispielsweise Bisphenol A oder 2,3,4-Trihydroxybenzophenon.

Als bevorzugte Basispolymere werden je nach geforderter Ätzresistenz die alternierenden Copolymere aus Maleinsäureanhydrid und Allyltrimethylsilan bzw. aus Maleinsäureanhydrid und Styrol eingesetzt. Das Mol-Gewicht der Basispolymere kann allgemein zwischen 1000 und 100000 liegen, im angegebenen Fall jedoch bevorzugt zwischen 1500 und 10000.

Die im Basispolymer vorhandenen, hydrophoben Anhydridgruppen sind in üblichen, kommerziell erhältlichen wäßrig-alkalischen Entwicklern nicht oder nur wenig hydrolisierbar. Der Photoresist zeigt daher in diesen Medien keine oder nur eine sehr geringe Löslichkeit. Trotzdem können die üblichen wäßrig-alkalischen Entwickler verwendet werden, wenn ihnen 0,01 bis 10 Gewichtsprozent, bevorzugt 0,1 bis 0,7 Gewichtsprozent primäre oder sekundäre Amine oder Ammoniak zugesetzt werden. Neben dem vorteilhaft verwendeten Ammoniak sind alle primären und sekundären Monoamine geeignet, die im wäßrig-alkalischen Medium des Entwicklers löslich sind. Das Entwicklungsverfahren beruht auf der selektiven Diffusion der Amine aus dem Entwickler in die belichteten Bereiche und der spontanen Reaktion dieser Amine mit den Anhydridgruppen zu Amidocarbonsäureeinheiten. Letztere besitzen eine hohe Alkalilöslichkeit und bewirken damit eine hohe Entwicklungsrate der belichteten Resistbereiche im alkalischen Medium.

Ein großer Vorteil der in den Photoresists erfindungsgemäß verwendeten Basispolymere in Verbindung mit diesem Entwicklungsverfahren ist der große Polaritätsunterschied zwischen den hydrophoben unbelichteten Bereichen und den belichteten Bereichen, die erst während des Entwicklungsschrittes hydrophiliert werden:

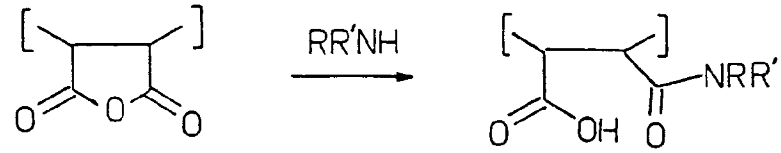


Dieser hohe Polaritätswechsel ist bei den üblichen Photoresists nicht erreichbar, da in diesen Materialien alkalilösliche Basispolymere verwendet werden.

Im folgenden wird anhand von zwei herausgegriffenen Resistzusammensetzungen, zwei Entwicklerlösungen und drei Ausführungsbeispielen sowie den dazugehörigen sechs Figuren die Anwendung des erfindungsgemäßen Photoresists sowohl für Einlagen- als auch für Zweilagentechnik verdeutlicht.

1. Herstellen einer Lösung der Resistzusammensetzung a)

Durch Auflösung von 16 Gewichtsteilen eines alternierenden Copolymers aus Maleinsäureanhydrid und Styrol als Basispolymer und 4 Gewichtsteilen eines Diesters der Naphthochinon-4-sulfonsäure mit Bisphenol A als photoaktive Komponente in 80 Gewichtsteilen (2-Methoxy-1-propyl)-acetat wird eine gebrauchsfertige Photoresistlösung a) hergestellt.

2. Herstellen einer Lösung der Resistzusammensetzung b)

Durch Auflösen von 16 Gewichtsteilen eines alternierenden Copolymers aus Maleinsäureanhydrid und Allyltrimethylsilan als Basispolymer und 4 Gewichtsteilen eines Diesters der Naphthochinon-4-sulfonsäure mit Bisphenol A als photoaktive Komponente in 80 Gewichtsteilen (2-Methoxy-1-propyl)-acetat wird eine gebrauchsfertige Resistlösung b) hergestellt.

3. Herstellen der Entwicklerlösung c)

1 Gewichtsteil des kommerziell erhältlichen Entwicklers AZ 400 K wird mit 5 Gewichtsteilen Wasser verdünnt und mit 0,03 Gewichtsteilen Ammoniak versetzt.

4. Herstellen der Entwicklerlösung d)

1 Gewichtsteil des Entwicklers AZ 400 K wird mit 5 Gewichtsteilen Wasser verdünnt und mit 0,02 Gewichtsteilen n-Butylamin versetzt.

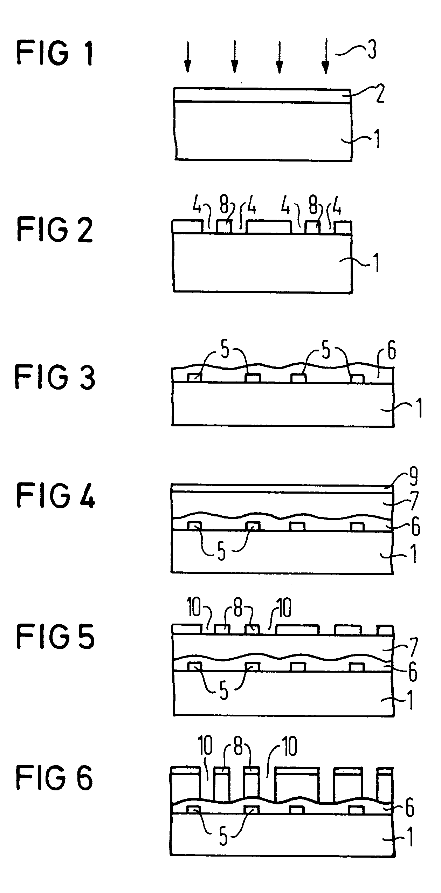

5. Beschichten, Photostrukturieren und Entwickeln des Resists a) (siehe auch Figuren 1 und 2)

Auf einem 3-Zoll-Silizium-Wafer 1 wird durch Aufschleudern von Resistlösung a eine Photoresistschicht 2 erzeugt. Bei 110°C auf der Hotplate wird die Resistschicht getrocknet und weist nun eine Schichtdicke von 1,0 μm auf. Mit einer Photomaske, die Linienstrukturen von 2,0 bis 0,5 μm besitzt, wird nun eine Kontaktbelichtung 3 durchgeführt. Bei einer Wellenlänge von 248 nm beträgt die erforderliche Dosis 80 mJ/cm². Die Maske wird entfernt und der Wafer nun 60 Sekunden in einem Sprühentwickler mit der Entwicklerlösung c behandelt. Der Wafer wird nun mit Wasser gespült und bei 110°C auf der Hotplate getrocknet. Rasterelektronenmikroskopaufnahmen zeigen die in Figur 2 schematisch dargestellten Strukturen, die sowohl für Stege 8 als auch für Gräben 4 eine Auflösung bis 0,5 μm erreichen. Das bedeutet, daß in der Photoresistschicht 2 nach der Entwicklung Photoresiststrukturen bestehen bleiben, die bis zu einer Strukturbreite der Gräben 4 und der Stege 8 von 0,5 μm ein sauberes Bild der auf der Maske vorgegebenen Struktur darstellen und die außerdem noch steile Flanken aufweisen. Der bei der Entwicklung unbelichteter Resistbereiche gemessene Dunkelabtrag liegt bei 3 nm.

6. Strukturierungsvariante für eine Schicht der Resistzusammensetzung a)

Auf einem Substrat 1 wird wie in Beispiel 5 eine Schicht 2 der Resistzusammensetzung a) in einer Stärke

von 1,0 µm aufgebracht und getrocknet. Die Belichtung erfolgt diesmal mit einer Dosis von 70 mJ/cm² und zur Entwicklung wird die Entwicklerlösung d) verwendet. Eine rasterelektronenmikroskopische Analyse der erzeugten Photoresiststrukturen zeigt ebenfalls eine Auflösung bis zu einer Strukturbreite von 0,5 µm, sowohl für Stege als auch für Gräben bei gleichzeitig hoher Flankensteilheit. Der Dunkelabtrag beträgt 5 nm.

7. Anwendung der Resistzusammensetzung b) als Topresist (siehe auch Figuren 3 bis 6)

Auf einem beliebigen Substrat 1, welches zum Beispiel eine integrierte Schaltung darstellt, die mit einer Isolationsschicht 6 abgedeckte Leiterbahnen 5 aufweist und, wie in Figur 3 dargestellt, eine unebene Oberfläche besitzt, wird eine 1,8 µm dicke Schicht eines käuflichen Photoresists (MP 1450 J) aufgebracht und bei 210° vernetzt. Auf dieser planarisierend wirkenden Photoresistschicht 7, welche den Bottom-Resist darstellt, wird nun eine 1 µm dicke Schicht der Resistzusammensetzung b) aufgebracht und bei 110° auf der Hotplate getrocknet. Figur 4 zeigt einen schematischen Querschnitt durch den so erhaltenen Schichtaufbau. Über eine Maske, die verschiedene Linienstrukturen von 2,0 bis 0,5 µm Breite besitzt, wird die Resistschicht 9 bei einer Wellenlänge von 248 nm und einer Dosis von 70 mJ/cm² kontaktbelichtet. Figur 5 zeigt den Aufbau, nachdem die Photoresistschicht 9 mit Hilfe der Entwicklerlösung d behandelt wurde. Nach 75 Sekunden Entwicklung wurde mit Wasser gespült und bei 110°C getrocknet. Auch hier erweisen rasterelektronenmikroskopische Aufnahmen, daß sowohl Gräben 10 als auch Stege 8 bis zu einer Breite von 0,5 µm gut aufgelöst sind und hohe Flankenwinkel aufweisen. Ein Dunkelabtrag ist nicht festzustellen.

Unter Verwendung der strukturierten Resistschicht 9 als Ätzmaske wird der Aufbau nun unter anisotropen Sauerstoff-RIE-Bedingungen in einem Plasmareaktor bei 6 mTorr Sauerstoff-Gasdruck und 410 Volt Bias-Spannung geätzt. Die in der Photoresistschicht 9 erzeugte Struktur wird dabei sauber auf die darunterliegende Resistschicht 7 übertragen. Sowohl Stege als auch Gräben werden in der Bottomresistschicht bis 0,5 µm bei senkrechten Flanken aufgelöst, wie zum Beispiel in Figur 6 gut zu erkennen ist.

Die Ausführungsbeispiele, die nur stellvertretend für beliebig viele weitere Ausführungsformen herausgegriffen sind, machen noch einmal die Vorteile des erfindungsgemäßen Photoresists deutlich. Durch leichte Variation der Zusammensetzung des Photoresists ergeben sich vielfältige Anwendungsmöglichkeiten, sowohl in der Einlagen- als auch in der Zweilagentechnik. Die Anwendung ist dabei einfach und in gebräuchlichen Vorrichtungen durchführbar. Der Resist ist für tiefes UV geeignet und zeigt dort eine gute Auflösung bis mindestens 0,5 µm bei hohem Kontrast und steilen zu erzielenden Flankenwinkeln. Die Ätzbeständigkeit und die Lichtempfindlichkeit sind hoch, der Dunkelabtrag dabei gering, so daß eine maßhaltige Strukturerzeugung bzw. Strukturübertragung möglich wird.

## Patentansprüche

1. Photoresist zur Strukturerzeugung im sub-µm-Bereich, enthaltend ein entwickelbares Basispolymer und ein Chinodiazid als photoaktive Komponente, wobei das Basispolymer ein Copolymer aus einem ungesättigten Anhydrid und einem weiteren Monomer ist, welches ausgewählt ist aus

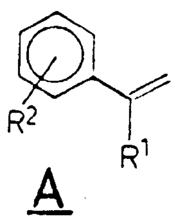
A
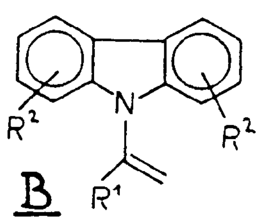
B
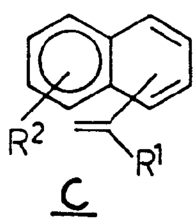
C
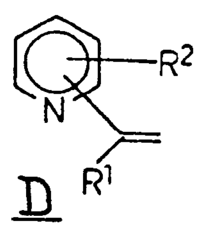
D

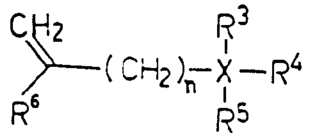

E

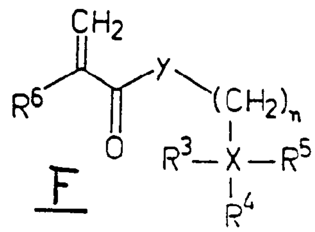

F

wobei R1 und R2 unabhängig voneinander für H, Alkyl, Aryl oder Halogen stehen,
R3 bis 5 unabhängig voneinander je einen Alkyl-Aryl-Alkoxy-Aryloxi- oder Arylaklkylrest darstellen, R6 H oder Alkyl bedeutet, Y für O oder NH und X für Si oder Sn steht und $0 \leqq n$ kleiner gleich 3 ist
und wobei der Photoresist nach der Belichtung ohne weitere zusätzliche Behandlung mit einer wäßrig alkalischen Entwicklerlösung entwickelbar ist, die 0,01 bis 10 Gewichtsprozent primäre oder sekundäre Amine oder Ammoniak enthält.

**2.** Photoresist nach Anspruch 1,
bei dem das Basispolymer cyclische Anhydridfunktionen aufweist.

**3.** Photoresist nach Anspruch 1 oder 2,
bei dem das Basispolmyer zu 10 bis 55 Mol-Prozent aus Maleinsäure Anhydrid-Monomeren abgeleitet ist.

**4.** Photoresist nach einem der Ansprüche 1 bis 3,
bei dem das Basispolymer als regelmäßig wiederkehrende Einheiten den Strukturformeln H, I und K gehorchende Fragmente in der Kette aufweist,

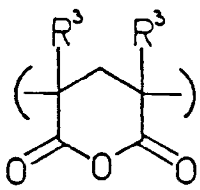

H

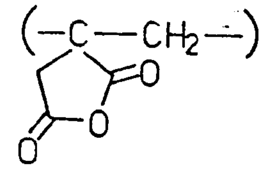

I

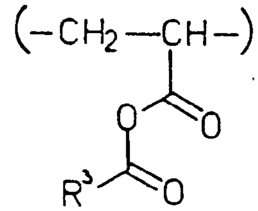

K

wobei R3 Wasserstoff, Alkyl, Aryl, Halogen, halogensubstituiertes Alkyl bzw. Aryl oder einen olephinisch ungesättigten Rest bedeuten.

**5.** Photoresist nach mindestens einem der Ansprüche 1 bis 4,
bei dem das Basispolymer von Anhydridmonomeren abgeleitet ist, die zumindest einer der Strukturen L, M, N oder O gehorchen

L

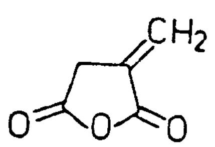

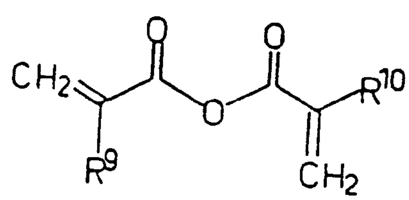

M

N 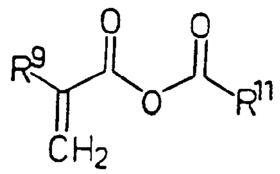 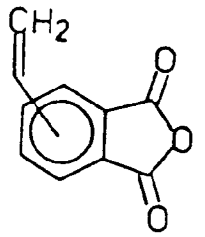 O

wobei R9 und R10 für H oder Alkyl stehen und R11 einen Alkyl- oder Aryl-Rest darstellt.

6. Photoresist nach einem der Ansprüche 1 bis 5, bei dem die photoaktive Komponente von einer der Strukturen P, Q, oder R abgeleitet ist,

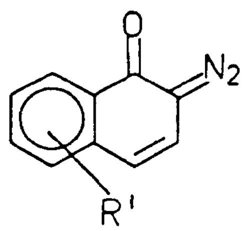 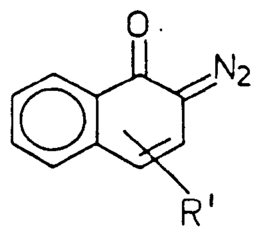 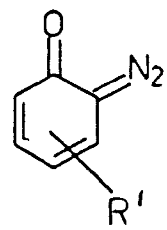

P Q R

wobei R′ für $-SO_3R$ oder $-CO_2R$ steht und R für Alkyl, Aryl, Halogenalkyl, Halogenaryl oder Halogen steht.

7. Photoresist nach einem der Ansprüche 1 bis 6, bei dem das Basispolymer ein alternierendes Copolymer ist, welches von Maleinsäureanhydrid- und Styrol-Monomeren abgeleitet ist.

8. Photoresist nach einem der Ansprüche 1 bis 7, bei dem das Basispolymer ein alternierendes Copolmyer aus Maleinsäureanhydrid- und Allyltrimethylsilaneinheiten ist.

9. Photoresist nach einem der Ansprüche 1 bis 8, bei dem das Mol-Gewicht des oder der Basispolymeren zwischen 1000 und 100000 liegt.

10. Photoresist nach Anspruch 9, bei dem das Mol-Gewicht des oder der Basispolymeren zwischen 1500 und 10000 liegt.

11. Photoresist nach Anspruch 6, bei dem die photoaktive Komponente in einem im getrockneten Zustand bestimmten Anteil von 2 bis 35 Gewichtsprozent im Photoresist enthalten ist.

## Claims

1. Photoresist for pattern generation in the sub-µm range, containing a developable base polymer and a quinone diazide as photoactive component, the base polymer being a copolymer of an unsaturated anhydride and a further monomer selected from

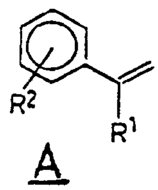
A

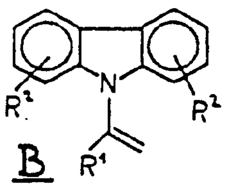
B

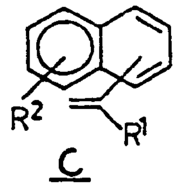
C

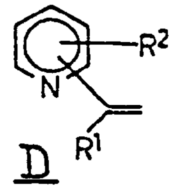
D

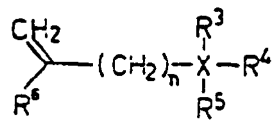
E

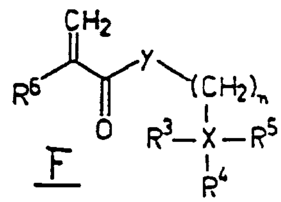
F

where R1 and R2 are, independently of one another, H, alkyl, aryl or halogen,
R3 to R5 are in each case, independently of one another, an alkyl-aryl-alkoxy-aryloxy radical or an arylalkyl radical, R6 is H or alkyl, Y is O or NH, X is Si or Sn and 0 ≦ n less than/equal to 3,
and the photoresist being developable after the exposure, without further additional treatment, with an aqueous alkaline developer solution containing 0.01 to 10% by weight of primary or secondary amines or ammonia.

2. Photoresist according to Claim 1, in which the base polymer contains cyclic anhydride functions.

3. Photoresist according to Claim 1 or 2, in which 10 to 55 mole percent of the base polymer is derived from maleic anhydride monomers.

4. Photoresist according to one of Claims 1 to 3, in which the base polymer contains fragments in the chain which conform to the structural formulae H, I and K as regularly repeating units,

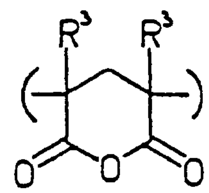
H

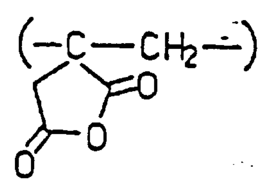
I

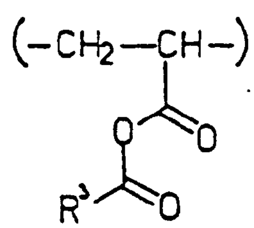
K

where R3 is hydrogen, alkyl, aryl, halogen, halogen-substituted alkyl or aryl, or an olephinically unsaturated radical.

5. Photoresist according to at least one of Claims 1 to 4, in which the base polymer is derived from anhydride monomers which conform to at least one of the structures L, M, N or O

L

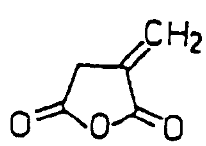

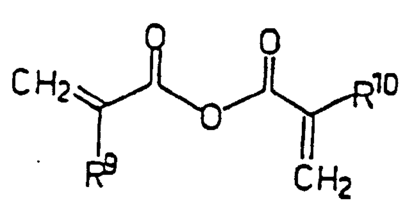
M

N 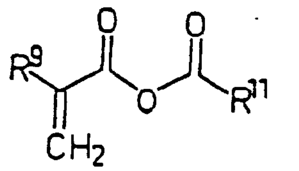

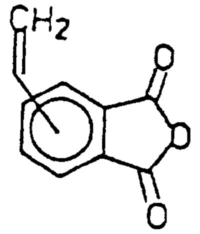 O

where R9 and R10 are H or alkyl, and R11 is an alkyl or aryl radical.

6. Photoresist according to one of Claims 1 to 5, in which the photoactive component is derived from one of the structures P, Q, or R,

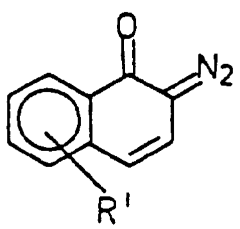

P

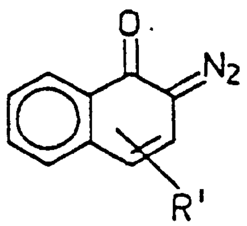

Q

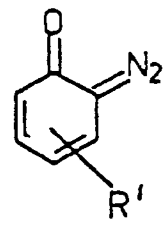

R

where R′ is $-SO_3R$ or $-CO_2R$ and R is alkyl, aryl, haloalkyl, haloaryl or halogen.

7. Photoresist according to one of Claims 1 to 6, in which the base polymer is an alternating copolymer derived from maleic anhydride monomers or styrene monomers.

8. Photoresist according to one of Claims 1 to 7, in which the base polymer is an alternating copolymer of maleic anhydride units and allyltrimethylsilane units.

9. Photoresist according to one of Claims 1 to 8, in which the molecular weight of the base polymer(s) is between 1,000 and 100,000.

10. Photoresist according to Claim 9, in which the molecular weight of the base polymer(s) is between 1,500 and 10,000.

11. Photoresist according to Claim 6, in which the photoactive component is contained in a proportion, determined in the dry state, of 2 to 35% by weight in the photoresist.

**Revendications**

1. Résine photosensible pour la production de structures d'une taille inférieure au micron, contenant un polymère de base développable et un quinodiazide en tant que composant actif du point de vue photochimique, le polymère de base étant un copolymère d'un anhydride insaturé et d'un autre monomère, qui est choisi parmi

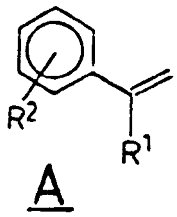
A
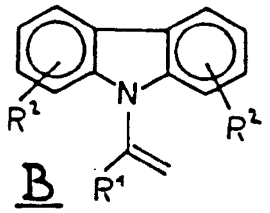
B
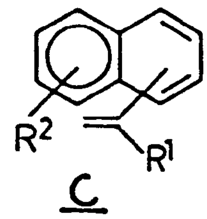
C
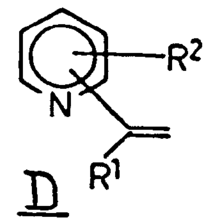
D

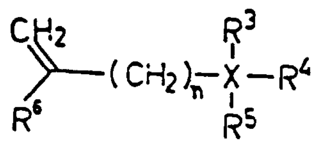
E
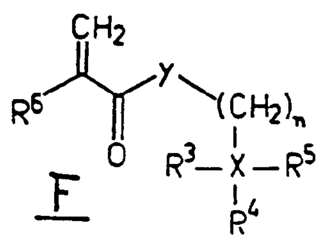
F

R1 et R2 représentant, d'une manière indépendante l'un de l'autre, H, un alkyle, un aryle ou un halogène, R3 à 5 représentant, d'une manière indépendante l'un de l'autre, respectivement un reste alkyle-aryle-alcoxy-aryloxy ou arylalkyle, R6 représentant H ou un alkyle, Y représentant O ou NH, et X représentant Si ou Sn, avec $0 \leqq n \leqq 3$, et
la résine photosensible pouvant être développée, après exposition et sans autre traitement supplémentaire, au moyen d'une solution alcaline aqueuse de développement, qui contient entre 0,01 et 10 pour cent en poids d'une amine primaire ou secondaire ou d'ammoniaque.

2. Résine photosensible suivant la revendication 1, dans laquelle le polymère de base comporte des fonctions d'anhydride cycliques.

3. Résine photosensible suivant la revendication 1 ou 2, dans laquelle le polymère de base est dérivé, pour 10 à 55 pour cent en moles, de monomères d'anhydride de l'acide maléïque.

4. Résine photosensible suivant l'une des revendications 1 à 3, dans laquelle le polymère de base possède, en tant qu'unités se répétant régulièrement, des fragments appartenant aux formules de structure H, I et K dans la chaîne

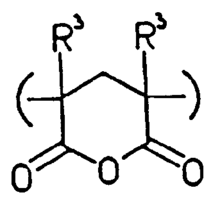
H
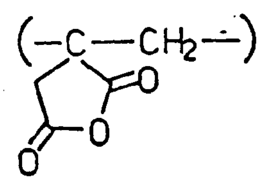
I
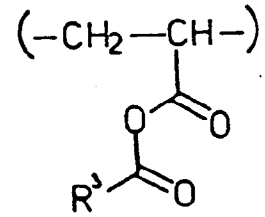
K

R3 désignant l'hydrogène, un alkyle, un aryle, un halogène, un alkyle ou un aryle à halogène substitué ou un reste insaturé en oléfine.

5. Résine photosensible suivant au moins l'une des revendications 1 à 4, dans laquelle le polymère de base est dérivé de monomères d'anhydride, qui appartiennent au moins à l'une des structures L, M, N ou O

L 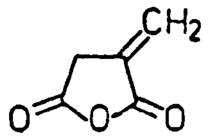

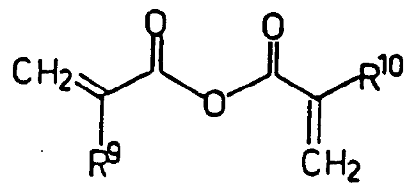 M

N 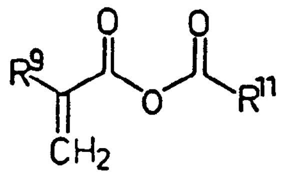

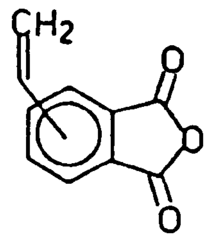 O

R9 et R10 désignant H ou un alkyle, et R11 désignant un reste alkyle ou un reste aryle.

6. Résine photosensible suivant l'une des revendications 1 à 5, dans laquelle le composant actif du point de vue photochimique est tiré de l'une des structures P, Q ou R

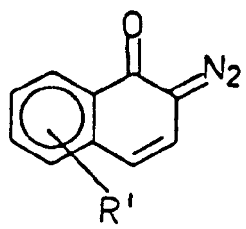

P

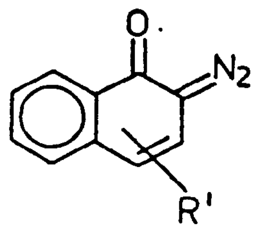

Q

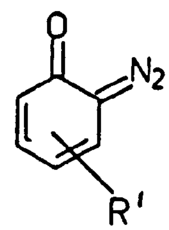

R

R' représentant $-SO_3$ ou $-CO_2R$ et R représentant un alkyle, un aryle, un alkyle d'halogène, un aryle d'halogène ou un halogène.

7. Résine photosensible suivant l'une des revendications 1 à 6, dans laquelle le polymère de base est un copolymère alterné, qui est tiré de monomères de l'anhydride de l'acide maléïque et de monomères de styrène.

8. Résine photosensible suivant l'une des revendications 1 à 7, dans laquelle le polymère de base est un copolymère alterné obtenu à partir d'unités d'anhydride de l'acide maléïque et d'allyltriméthylsilane.

9. Résine photosensible suivant l'une des revendications 1 à 8, dans laquelle le poids molaire du ou des polymères de base est compris entre 1000 et 100000.

10. Résine photosensible suivant la revendication 9, dans laquelle le poids molaire du ou des polymères de base est compris entre 1500 et 10000.

11. Résine photosensible suivant la revendication 6, dans laquelle le composant actif du point de vue photochimique est contenu en un pourcentage, qui est déterminé à l'état sec, de 2 à 35 pour cent en poids dans la résine photosensible.

FIG 1

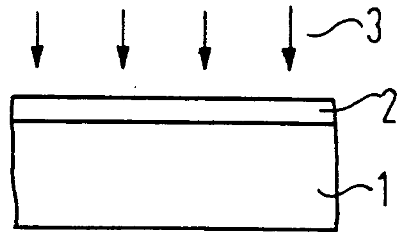


FIG 2

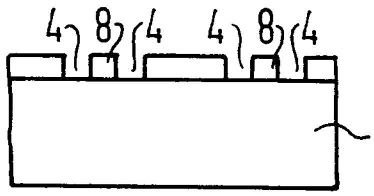


FIG 3

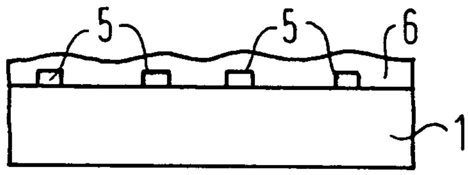


FIG 4

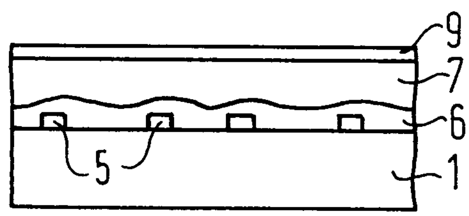


FIG 5

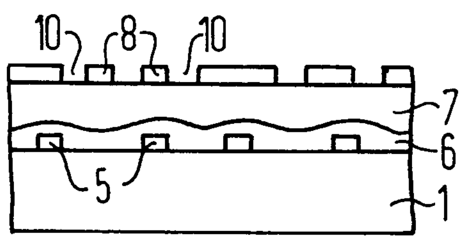


FIG 6